# FASCICULE DE BREVET EUROPEEN

(11) **EP 3 316 295 B1**
(45) Date de publication et mention de la délivrance du brevet: **16.06.2021**
(21) Numéro de dépôt: 17164858.7
(22) Date de dépôt: 04.04.2017
(51) Int. Cl.: H01L 23/58, H01L 25/065

(54) **DISPOSITIF COMPRENANT UN EMPILEMENT DE PUCES ÉLECTRONIQUES**
VORRICHTUNG MIT EINEM STAPEL ELEKTRONISCHER CHIPS
DEVICE COMPRISING A STACK OF ELECTRONIC CHIPS

(30) Priorité: 31.10.2016 FR 1660568
(43) Date de publication de la demande: 02.05.2018
(73) Titulaire: STMICROELECTRONICS (ROUSSET) SAS, 13790 Rousset (FR)
(72) Inventeur: CHAMPEIX, Clément, 42160 SAINT-CYPRIEN (FR); BORREL, Nicolas, 13500 MARTIGUES (FR)
(74) Mandataire: Cabinet Beaumont

(56) Documents cités:
- WO-A1-2011/155114
- WO-A1-2015/000813
- FR-A1- 2 910 708
- US-A1- 2003 008 432
- US-B1- 7 898 090

## Description

### Domaine

La présente demande concerne le domaine des puces électroniques, et vise en particulier un dispositif comprenant un empilement de puces électroniques interconnectées.

### Exposé de l'art antérieur

Certaines puces électroniques telles que des puces de cartes bancaires peuvent contenir des données confidentielles susceptibles d'être convoitées par des pirates. Ces données confidentielles peuvent être contenues dans des circuits situés du côté de la face avant de la puce. Pour obtenir ces données, un pirate peut mener une attaque à partir de la face arrière de la puce.

Dans un type d'attaque, dit attaque par gravure, le pirate grave une partie de la face arrière de la puce. A partir de cette partie gravée, le pirate grave des cavités de quelques micromètres de largeur, par exemple en utilisant un faisceau d'ions, qui s'étendent vers la face avant jusqu'au niveau des circuits. Des contacts électriques avec des éléments des circuits sont ensuite créés dans ces cavités, et le pirate utilise ces contacts pour analyser la puce en fonctionnement.

Dans un autre type d'attaque, le pirate balaye par exemple la face arrière de la puce par des impulsions laser. L'impact du laser perturbe le fonctionnement de la puce. C'est l'observation des conséquences de ces perturbations sur l'activité des circuits qui permet au pirate de mener à bien son attaque. Pour perturber le fonctionnement de la puce, le pirate peut aussi appliquer des potentiels positifs ou négatifs au moyen d'une sonde en contact avec la face arrière, ou induire des courants ou des tensions dans des éléments des circuits au moyen d'une bobine disposée à proximité de la face arrière. Ce type d'attaque est appelé attaque par injection de faute.

Une telle puce comprenant des données confidentielles peut être comprise dans un empilement de puces interconnectées.

On s'intéresse ici à la protection contre des attaques, et en particulier contre des attaques par la face arrière, d'une puce contenue dans un empilement de puces interconnectées.

Le document WO2015/000813 décrit un ensemble électronique structurel.

Le document US2003/008432 décrit un procédé et un dispositif pour sécuriser un empilement de puces et une configuration de puces réalisés de façon pluridimensionnelle.

Le document US7898090 décrit un capot de sécurité à réseau de billes conductrice d'usage général.

Le document WO2011/155114 décrit un circuit de protection, un dispositif semiconducteur et un équipement électronique.

### Résumé

L'invention prévoit un dispositif tel que défini dans la revendication 1. Des modes de réalisation privilégiés sont définis dans les revendications dépendantes. Les exemples de la présente description non couverts par les revendications ne font pas partie de l'invention.

### Brève description des dessins

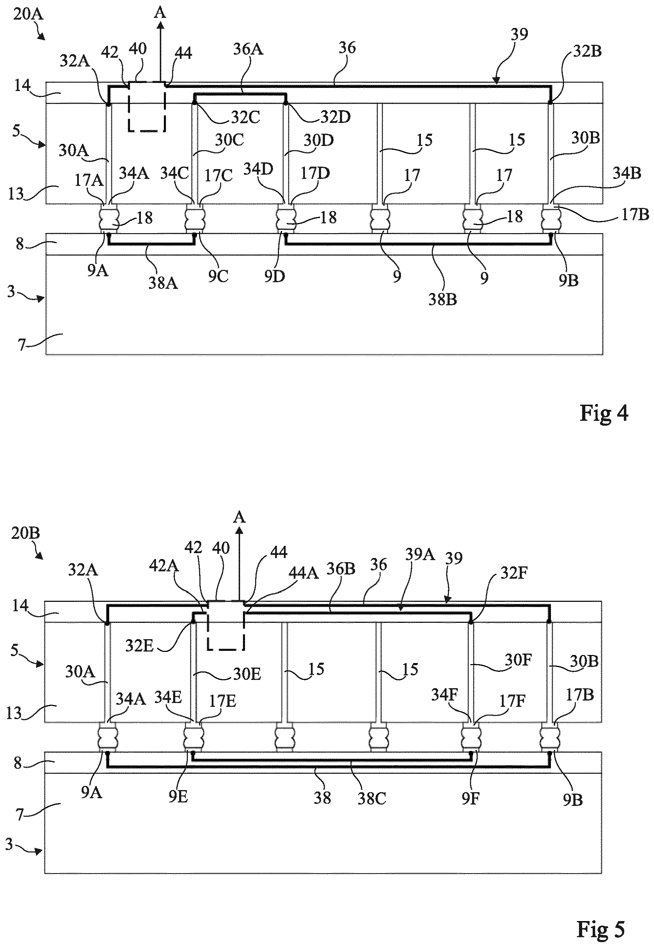

Seule la figure 5 montre toutes les caractéristiques de l'invention définie à la revendication Les autres figures sont utiles à la compréhension de l'invention et/ou des aspects relatifs à ces figures peuvent être combinés à ceux de l'invention.

Ces caractéristiques et avantages, ainsi que d'autres, seront exposés en détail dans la description suivante faite à titre non limitatif en relation avec les figures jointes parmi lesquelles :
la figure 1 est une vue schématique en coupe d'un exemple de dispositif comportant un empilement de puces électroniques ;
la figure 2 est une vue schématique en coupe d'un exemple de dispositif comportant un empilement de puces électroniques utile à la compréhension de l'invention ;
la figure 3 est un schéma en perspective illustrant des éléments de protection d'un dispositif comportant un empilement de puces électroniques utile à la compréhension de l'invention ;
la figure 4 est une vue schématique en coupe d'un exemple de dispositif comportant un empilement de puces électroniques utile à la compréhension de l'invention;
la figure 5 est une vue schématique en coupe d'un mode de réalisation d'un dispositif comportant un empilement de puces électroniques selon l'invention;
la figure 6 est une vue schématique en coupe d'un autre exemple de dispositif comportant un empilement de puces électroniques utile à la compréhension de l'invention ;
la figure 7 est une vue schématique en coupe d'un autre exemple de dispositif comportant un empilement de puces électroniques utile à la compréhension de l'invention ; et
la figure 8 est un diagramme illustrant un exemple d'un mode de réalisation d'un procédé de commande d'un dispositif comprenant un empilement de puces électroniques. Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des exemples et du mode de réalisation décrits ont été représentés et sont détaillés. En particulier, les circuits compris dans les puces des dispositifs décrits, notamment les circuits susceptibles de contenir des données confidentielles à protéger, n'ont pas été détaillés. En outre, les dispositifs décrits comportent des circuits de détection dont la réalisation n'a pas été détaillée. La réalisation de ces circuits de détection est en effet à la portée de l'homme du métier à partir des indications fonctionnelles de la présente description.

Dans la description qui suit, lorsque l'on fait référence à des qualificatifs de position absolue, tels que les termes "haut", "bas", etc., ou relative, tels que les termes "dessus", "dessous", "supérieur", "inférieur", etc., il est fait référence à l'orientation de l'élément concerné dans les figures concernées, étant entendu que, dans la pratique, les dispositifs décrits peuvent être orientés différemment.

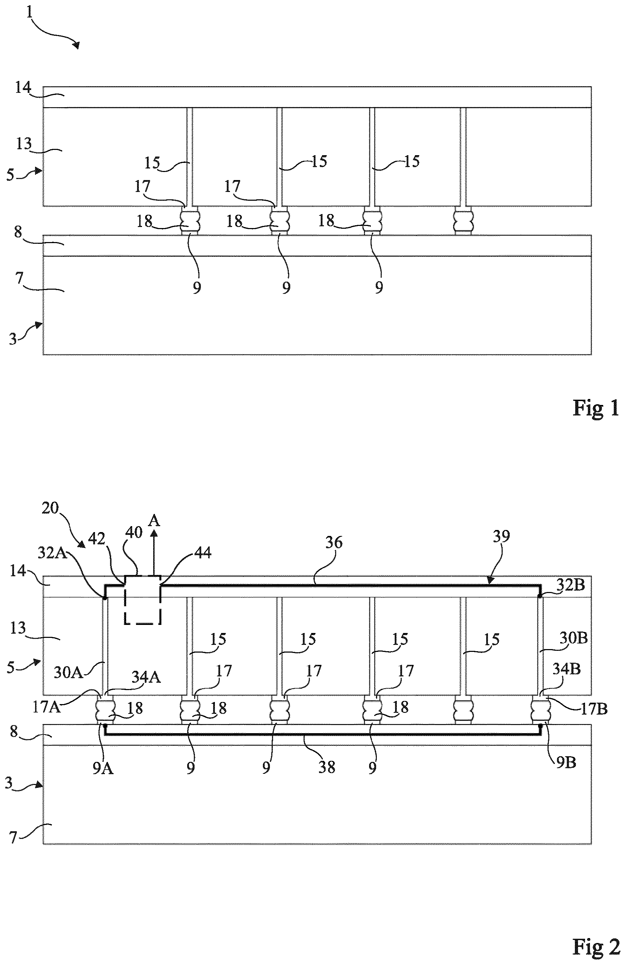

La figure 1 est une vue schématique en coupe illustrant un exemple d'un dispositif 1 comportant un empilement de puces électroniques. Le dispositif 1 comprend une puce 3, et une puce 5 située au-dessus de la puce 3. Les puces 3 et 5 ont chacune une face avant en partie supérieure et une face arrière en partie inférieure. La puce 3 se trouve ainsi du côté de la face arrière de la puce 5.

La puce 3 comprend un substrat semiconducteur 7. Le substrat 7 comprend, du côté de sa face supérieure (ou face avant), des éléments semiconducteurs de composants tels que des transistors ou des diodes de circuits non représentés. La puce 3 comprend en outre une couche d'interconnexion 8 recouvrant le substrat 7 du côté de sa face supérieure. La couche d'interconnexion 8 contient, au sein de couches isolantes, des pistes conductrices, non représentées, qui relient les composants des circuits de la puce 3. De plus, la puce 3 comprend, sur la face supérieure de la couche d'interconnexion 8, des plots de connexion 9 reliés électriquement aux circuits de la puce 3 par des pistes de la couche 8.

La puce 5 comprend un substrat semiconducteur 13. La puce 5 comprend des circuits situés du côté de sa face avant, ces circuits comprenant des composants formés dans et sur le substrat 13 du côté de la face supérieure du substrat 13. La puce 5 comprend une couche d'interconnexion 14 recouvrant le substrat 13 du côté de sa face supérieure (ou face avant). La couche d'interconnexion 14 contient, au sein de couches isolantes, des pistes conductrices, non représentées, qui relient les composants des circuits de la puce 5. La puce 5 comprend en outre des vias traversants 15. Par "via traversant", on entend ici un via traversant conducteur traversant entièrement le substrat 13 de part en part, de la face supérieure du substrat à la face inférieure (ou face arrière) du substrat. Les vias 15 ont chacun, côté face avant, une extrémité connectée aux circuits de la puce 5 par des pistes de la couche 14, et, côté face arrière, une extrémité connectée à un plot de connexion 17 situé sur la face arrière de la puce supérieure 5. Chaque plot de connexion 17 de la puce supérieure 5 est brasé à un plot de connexion 9 de la puce inférieure 3. Un matériau d'apport 18 peut être prévu entre les plots 9 et 17 pour réaliser le brasage. On obtient ainsi des connexions entre les circuits de la puce 3 et ceux de la puce 5.

On considère ici le cas où les circuits de la puce supérieure 5 contiennent des données confidentielles convoitées par un pirate. En présence de la puce 3 du côté de la face arrière de la puce 5, le pirate ne peut attaquer la face arrière de la puce 5. Pour obtenir les données convoitées, le pirate doit donc commencer par désolidariser les plots 9 et 17 afin de retirer la puce 3 et d'accéder à la face arrière de la puce 5. Le pirate peut alors mener son attaque à partir de la face arrière de la puce 5. Pendant l'attaque le pirate connecte la puce 5 à une source d'alimentation pour la mettre en fonctionnement. Eventuellement, le pirate peut en outre reconnecter électriquement les plots 9 et 17 par des fils conducteurs, de façon à rétablir la liaison électrique entre les deux puces tout en conservant un accès à la face arrière de la puce 5.

On cherche ici, dans un dispositif comportant un empilement de puces, à protéger une puce contre des attaques par sa face arrière lorsque cette puce a sa face arrière tournée vers une autre puce de l'empilement.

La figure 2 est une vue schématique en coupe d'un exemple de dispositif comportant un empilement de puces électroniques. Le dispositif 20 comprend les mêmes éléments que le dispositif 1 de la figure 1, agencés sensiblement de la même manière. Les éléments communs entre les deux dispositifs ne seront pas détaillés à nouveau ci-après.

La puce supérieure 5 du dispositif 20 comprend deux vias conducteurs traversants supplémentaires 30A et 30B. Chacun des vias 30A et 30B a une extrémité, respectivement 32A, 32B, située du côté de la face avant de la puce 5, et une autre extrémité, respectivement 34A, 34B, située du côté de la face arrière de la puce 5. Les extrémités supérieures 32A et 32B des vias 30A et 30B sont reliées électriquement entre elles par une piste conductrice 36 située dans la couche d'interconnexion 14 de la puce 5. Les extrémités inférieures 34A et 34B des vias 30A et 30B sont reliées électriquement entre elles par une piste conductrice 38 située dans la couche d'interconnexion 8 de la puce inférieure 3. Dans l'exemple représenté, la puce supérieure 5 comprend deux plots de connexion supplémentaires 17A et 17B situés en face arrière de la puce supérieure 5 et connectés respectivement aux extrémités 34A et 34B des vias 30A et 30B. De plus, la puce inférieure 3 comprend deux plots de connexion supplémentaires 9A et 9B situés en face avant de la puce 3 et connectés respectivement à une première et à une deuxième extrémités de la piste 38, les plots 17A et 17B étant brasés respectivement aux plots 9A et 9B. Le dispositif comprend ainsi une boucle conductrice 39 comprenant les vias traversants 30A et 30B reliés en série par les pistes 36 et 38.

La puce supérieure 5 comprend en outre un circuit de détection 40 configuré pour surveiller une caractéristique électrique de la boucle 39, par exemple une absence de continuité électrique de la boucle 39.

En fonctionnement normal, la présence de la puce inférieure 3 du côté de la face arrière de la puce supérieure 5 empêche le pirate d'accéder à la face arrière de la puce 5 pour procéder à une attaque. La boucle 39 est intacte, et le circuit 40 ne détecte aucune attaque.

Lors d'une tentative d'attaque visant à obtenir des données confidentielles de la puce supérieure 5, le pirate retire la puce inférieure 3 pour accéder à la face arrière de la puce 5. Pour cela, le pirate désolidarise les plots de connexion 17, 17A, 17B de la puce 5 des plots de connexion 9, 9A, 9B de la puce 3. Du fait qu'une partie de la boucle 39 est comprise dans la puce inférieure 3, la boucle 39 est rompue. Lorsque la puce 5 est remise en fonctionnement par le pirate pour analyser son fonctionnement, l'interruption de la boucle 39 est détectée par le circuit 40 qui émet alors un signal d'alerte A. A la suite de la génération de ce signal d'alerte dans la puce 5, des contre-mesures sont prises pour stopper l'attaque, par exemple en détruisant les données confidentielles ou en arrêtant le fonctionnement des circuits de la puce 5.

La puce 5 du dispositif 20 est ainsi protégée contre des attaques par sa face arrière.

A titre d'exemple, la puce inférieure 3 a des dimensions latérales supérieures ou égales à celles de la puce supérieure 5 et l'ensemble de la face arrière de la puce 5 est en vis-à-vis de la puce 3. A titre de variante, la puce 3 est située en vis-à-vis d'une partie seulement de la face arrière de la puce 5, correspondant aux circuits sensibles à protéger de la puce 5.

A titre d'exemple, pour pouvoir détecter une discontinuité de la boucle 39, le circuit de détection 40 est placé en série avec une portion conductrice de la boucle 39 dont on souhaite détecter une caractéristique électrique. Autrement dit, le circuit 40 est inclus dans la boucle 39. A titre d'exemple, le circuit de détection 40 est situé entre des noeuds 42 et 44 situés sur la piste 36 de façon à interrompre la piste 36. A titre de variante, le circuit de détection est situé entre la piste 36 et l'extrémité 32A du via 30A ou entre la piste 36 et l'extrémité 32B du via 30B.

Le circuit de détection 40 est alors configuré pour détecter une caractéristique électrique de la portion conductrice de la boucle 39 située à l'extérieur du circuit de détection 40. A titre de variante, plutôt que de surveiller la continuité électrique de la boucle 39, le circuit de détection 40 peut être adapté à surveiller une ou plusieurs autres caractéristiques électriques de la boucle 39, par exemple à comparer la valeur de la résistance électrique de la boucle 39 entre les noeuds 42 et 44 à une valeur de référence, ou encore à comparer à une durée de référence le temps mis par une impulsion électrique émise par le circuit 40 pour parcourir la boucle. Un avantage de ces alternatives est qu'elles permettent de détecter que les puces 3 et 5 ont été reconnectées par des fils conducteurs après avoir été désolidarisées, ce que ne permet pas de détecter une simple vérification de la continuité électrique de la boucle 39.

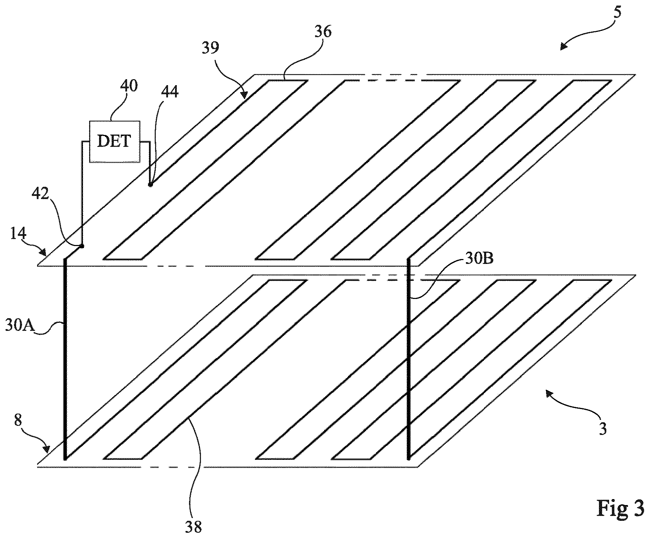

La figure 3 est un schéma en perspective illustrant plus en détail un exemple de réalisation de la boucle 39 du dispositif de la figure 2. Seules les pistes 36 et 38, les vias 30A et 30B et le circuit 40 ont été représentés sur la figure 3. Les couches d'interconnexion 8 et 14 ont été schématisées par deux plans parallèles.

A titre d'exemple, la piste 36 de la puce supérieure 5 a en vue de dessus la forme d'un serpentin disposé dans un plan sensiblement parallèle à la face supérieure de la puce. Le serpentin peut être disposé à un niveau de métallisation de la puce situé au-dessus de celui des pistes d'interconnexion des circuits de la puce. A titre d'exemple, les circuits sensibles à protéger de la puce 5 sont disposés en partie ou en totalité dans une zone de la puce dans laquelle s'étend, en vue de dessus, le motif en serpentin. A titre d'exemple, les circuits sensibles sont disposés en partie ou en totalité dans une zone de la puce dont chaque point est situé en vue de dessus entre deux portions de la piste 36 séparées d'une distance inférieure à 5 µm, de préférence inférieure à 2 pm.

Un avantage de cette disposition de la piste 36 est qu'elle permet de protéger en outre la puce 5 contre une attaque éventuelle à partir de sa face avant. En effet, si un pirate tentait d'accéder aux composants des circuits sensibles de la puce 5 au travers de la couche d'interconnexion 14, il interromprait inévitablement la piste 36, et le circuit 40 détecterait l'attaque. La puce supérieure 5 est ainsi avantageusement protégée par un seul circuit 40 à la fois contre des attaques par sa face avant et contre des attaques par sa face arrière. La protection de la puce supérieure 5 est ainsi obtenue par un nombre particulièrement réduit de composants.

Dans l'exemple de la figure 3, la piste 38 de la puce inférieure 3 a aussi en vue de dessus la forme d'un serpentin, par exemple identique ou similaire à la forme de serpentin de la piste 36.

Ceci permet de protéger la puce 5, toujours au moyen du même circuit 40, contre une attaque dans laquelle le pirate tenterait de retirer seulement une portion de la puce inférieure 3, par exemple en gravant une ouverture traversante dans la puce inférieure 3, en vue d'accéder à une partie de la face arrière de la puce 5 sans désolidariser les deux puces. Du fait du motif en serpentin de la piste 38, lors d'une telle tentative d'attaque, le pirate interromprait inévitablement la piste 38, et l'attaque serait ainsi détectée par le circuit 40.

A titre d'exemple, les circuits sensibles de la puce 5 sont en partie ou en totalité disposés en vis-à-vis d'une zone de la puce 3 dans laquelle le motif en serpentin de la piste 38 s'étend en vue de dessus. Pour accéder aux composants des circuits sensibles de la puce 5 en passant par sa face arrière, le pirate doit retirer de la puce 3 une portion dont les dimensions latérales sont supérieures à celles des accès aux composants que le pirate réaliserait s'il voulait attaquer la puce 5 par sa face avant. Ainsi, le serpentin 38 peut être moins resserré que le serpentin 36, par exemple les circuits sensibles de la puce 5 sont en partie ou en totalité disposés dans une zone dont chaque point situé en vue de dessus entre deux portions de la piste 38 séparées d'une distance inférieure à 50 µm, de préférence inférieure à 20 µm. A titre de variante, le serpentin 38 et le serpentin 36 sont similaires, les circuits sensibles de la puce 5 étant en partie ou en totalité disposés dans une zone dont chaque point est situé en vue de dessus entre deux portions de la piste 38 séparées d'une distance inférieure à 5 µm, de préférence inférieure à 2 pm.

La figure 4 est une vue en coupe schématique d'une variante de réalisation du dispositif 20 de la figure 2. La figure 4 illustre plus particulièrement un dispositif 20A comprenant des éléments similaires à ceux du dispositif 20 de la figure 2, agencés d'une manière similaire. Les éléments communs entre les deux dispositifs ne seront pas décrits à nouveau ci-après. Dans la suite, seules les différences entre les dispositifs 20A et 20 seront mises en exergue.

Dans le dispositif 20A, la boucle 39 comprend des vias conducteurs traversants supplémentaires 30C et 30D situés dans la puce 5. Les vias 30C et 30D ont chacun une extrémité, respectivement 32C et 32D, côté face avant de la puce 5, et l'autre extrémité, respectivement 34C et 34D, côté face arrière de la puce 5. Les extrémités 32C et 32D des vias 30C et 30D sont reliées par une piste supplémentaire 36A située dans la couche d'interconnexion 14 de la puce 5. Les extrémités 34C et 34D sont connectées à des plots de connexion supplémentaires, respectivement 17C et 17D, situés en face arrière de la puce 5.

La piste 38 de la puce 3 a été remplacée par des pistes 38A et 38B situées dans la couche d'interconnexion 8. De plus, la puce 3 comprend des plots de connexion supplémentaires 9C et 9D situés sur la face avant de la puce 3. La piste 38A relie le plot de connexion 9A au plot de connexion 9C, et la piste 38B relie le plot de connexion 9B au plot de connexion 9D. Les plots 9C et 9D sont brasés respectivement aux plots 17C et 17D.

La boucle 39 du dispositif 20A comprend ainsi les quatre vias 30A, 30B, 30C, 30D reliés en série par les pistes 36, 36A, 38A, 38B. Lorsque l'on parcourt la boucle 39, les pistes 36, 36A, 38A, 38B sont situées alternativement dans la puce supérieure 5 et dans la puce inférieure 3. Autrement dit, la portion de la boucle 39 dont on cherche à surveiller une caractéristique électrique passe alternativement par la puce 5 et par la puce 3 une pluralité de fois.

Bien que, dans l'exemple représenté, la puce 5 comprenne quatre vias traversants 30A, 30B, 30C, 30D disposés dans la puce 5, d'autres exemples sont possibles dans lesquels la boucle 39 comprend un nombre pair supérieur à quatre de vias connectés en série par des pistes situées alternativement dans la puce supérieure 5 et dans la puce inférieure 3.

Un avantage de l'exemple de la figure 4 est qu'il permet de renforcer la protection de la puce 5 contre des attaques. En effet, comme indiqué ci-dessus, un pirate convoitant les données confidentielles de la puce supérieure 5 pourrait, après avoir désolidarisé les puces 3 et 5, tenter de les reconnecter, par exemple par des fils conducteurs, de façon à conserver la liaison électrique entre les deux puces tout en préservant un accès à la face arrière de la puce supérieure 5. Ce faisant, il rétablirait la continuité électrique de la boucle 39, ce qui pourrait empêcher la détection de l'attaque par le circuit 40. Toutefois, cette reconnexion est d'autant plus difficile à faire que le nombre de vias à reconnecter est élevé. Le dispositif 20A de la figure 4 présente ainsi un niveau de protection renforcé par rapport au dispositif 20 de la figure 2.

La figure 5 est une vue en coupe schématique d'une autre variante de réalisation du dispositif 20 de la figure 2. Cette variante représentée à la figure 5 correspond à l'invention revendiquée. La figure 5 illustre plus particulièrement un dispositif 20B comportant des éléments similaires à ceux du dispositif 20 de la figure 2, agencés d'une manière similaire. Les éléments communs aux dispositifs 20 et 20B ne seront pas décrits à nouveau ci-après. Dans la suite, seules les différences entre les dispositifs 20 et 20B seront mises en exergue.

Le dispositif 20B comprend une boucle supplémentaire 39A comprenant deux vias traversants conducteurs supplémentaires 30E et 30F compris dans la puce supérieure 5. Les vias 30E et 30F ont, côté face avant, des extrémités respectives 32E et 32F et, côté face arrière, des extrémités respectives 34E et 34F. Les extrémités 34E et 34F sont reliées à des plots de connexion supplémentaires, respectivement 17E et 17F, situés sur la face arrière de la puce 5. La boucle 39A comprend en outre une piste supplémentaire 36B, située dans la couche d'interconnexion 14 de la puce supérieure 5 et reliant les extrémités 32E et 32F des vias 30E et 30F. La boucle 39A comprend en outre une piste 38C comprise dans la couche d'interconnexion 8 de la puce inférieure 3. La piste 38C relie entre eux des plots de connexion supplémentaires 9E et 9F disposés sur la face avant de la puce 3 et brasés respectivement aux plots 17E et 17F.

La boucle 39A du dispositif 20B comprend donc, reliés en série et dans l'ordre qui suit, dans la puce supérieure 5, le via 30E, la piste 36B et le via 30F, et, dans la puce inférieure 3, la piste 38C.

Dans ce mode de réalisation selon l'invention revendiquée, le circuit de détection 40 est placé non seulement en série avec une portion conductrice de la boucle 39, comme décrit précédemment, mais aussi en série avec une portion conductrice de la boucle 39A. Autrement dit, le circuit 40 est inclus dans la boucle 39A. A titre d'exemple, le circuit de détection 40 est situé entre des noeuds 42A et 44A situés sur la piste 36B de façon à interrompre la piste 36B. A titre de variante, le circuit de détection est situé entre la piste 36B et l'extrémité 32E du via 30E ou entre la piste 36B et l'extrémité 32F du via 30F.

Le circuit de détection 40 est alors configuré pour détecter une caractéristique électrique de la portion conductrice de la boucle 39A située à l'extérieur du circuit de détection 40. A titre d'exemple, le circuit de détection 40 du dispositif 20B est configuré pour détecter une caractéristique électrique de l'ensemble des deux boucles 39 et 39A. Selon l'invention, est détectée la présence d'une connexion électrique entre les boucles 39 et 39A, ou bien, une différence entre la résistance électrique de la boucle 39 entre les noeuds 42 et 44 et la résistance électrique de la boucle 39A entre les noeuds 42A et 44B.

Un avantage du mode de réalisation de la figure 5 est qu'il permet de renforcer la protection de la puce 5 contre des attaques. En effet, si un pirate convoitant les données confidentielles de la puce supérieure 5, après avoir désolidarisé les puces 3 et 5, tente de les reconnecter, par exemple par des fils conducteurs, il peut être amené à créer une connexion électrique entre les boucles, telle qu'un court-circuit, ou à provoquer une différence entre les résistances électriques des boucles. Ceci est détecté par le circuit 40 quand le pirate remet la puce 5 en fonctionnement pour poursuivre son attaque.

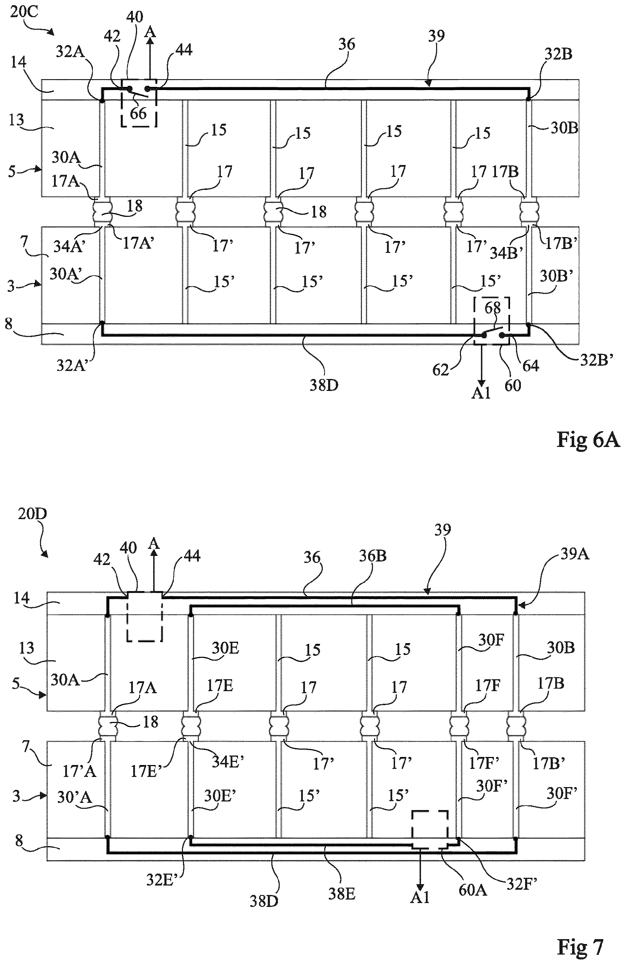

La figure 6 est une vue en coupe schématique d'un autre exemple utile à la compréhension de l'invention. Cette exemple constitue une variante de réalisation du dispositif 20 de la figure 2. La figure 6 illustre plus particulièrement un dispositif 20C comprenant des éléments similaires à ceux du dispositif 20 de la figure 2. Les éléments communs entre les deux dispositifs ne seront pas décrits à nouveau ci-après. Dans la suite, seules les différences entre les dispositifs 20C et 20 seront mises en exergue.

Le dispositif 20C diffère du dispositif 20 de la figure 2 essentiellement en ce que, dans le dispositif 20C, la puce inférieure 3 a sa face arrière tournée vers la face arrière de la puce supérieure 5. Autrement dit, dans le dispositif 20C, la face avant de la puce 3 correspond à sa face inférieure, et la face arrière de la puce 3 correspond à sa face supérieure.

Les plots de connexion 9 de la puce 3 ont été remplacés par des plots de connexion 17' situés sur sa face arrière. Les plots 17' sont reliés aux circuits de la puce inférieure 3 par des vias conducteurs traversants 15'. Les plots de connexion 17' de la puce inférieure 3 sont brasés aux plots de connexion 17 de la puce supérieure 5.

La puce 3 comprend en outre deux vias traversants conducteurs 30A' et 30B'. Les vias traversants 30A' et 30B' traversent le substrat 7 de part en part entre sa face supérieure et sa face inférieure. Les vias traversants 30A' et 30B' ont, côté face avant de la puce 3, des extrémités respectives 32A' et 32B', et, côté face arrière de la puce 3, des extrémités respectives 34A' et 34B'. Les extrémités 32A' et 32B' sont reliées entre elles par une piste supplémentaire 38D située dans la couche d'interconnexion 8 de la puce inférieure 3. Les extrémités 34A' et 34B' des vias 30A' et 30B' sont connectées à des plots de connexion supplémentaires 17A' et 17B' situés en face arrière de la puce inférieure 3. Les plots 17A' et 17B' de la puce inférieure 3 sont brasés respectivement aux plots 17A et 17B de la puce supérieure 5. Le dispositif 20C comprend ainsi une boucle 39 comportant en série et dans l'ordre qui suit, dans la puce 5, le via 30A, la piste 36 et le via 30B, et, dans la puce 3, le via 30B', la piste 38D et le via 30A'.

La puce inférieure 3 comprend en outre un circuit de détection supplémentaire 60 adapté à surveiller une caractéristique électrique de la boucle 39. Le circuit 60 est par exemple identique ou similaire au circuit 40. A titre d'exemple, pour pouvoir détecter une discontinuité de la boucle 39, le circuit de détection 60 est placé en série avec une portion conductrice de la boucle 39 dont on souhaite détecter une caractéristique électrique. Autrement dit, le circuit 60 est inclus dans la boucle 39. A titre d'exemple, le circuit de détection 60 est situé entre des noeuds 62 et 64 situés sur la piste 38D de façon à interrompre la piste 38D. A titre de variante, le circuit de détection est situé entre la piste 38D et l'extrémité 32A' du via 30A' ou entre la piste 38D et l'extrémité 32B' du via 30B'.

A titre d'exemple, le circuit de détection 40 comprend un interrupteur de coutournement 66 couplant les noeuds 42 et 44, permettant de connecter les noeuds 42 et 44 afin d'assurer la continuité électrique de la boucle 39 à l'intérieur du circuit 40. De manière similaire, le circuit de détection 60 peut comprendre un interrupteur de contournement 68 couplant les noeuds 62 et 64, permettant de connecter les noeuds 62 et 64 afin d'assurer la continuité électrique de la boucle 39 à l'intérieur du circuit 60. Chacun des circuits de détection 40 et 60 peut avoir une phase de détection au cours de laquelle le circuit de détection commande à l'état non passant son interrupteur de contournement, respectivement 66 et 68, et surveille une caractéristique électrique de la partie de la boucle 39 située à l'extérieur du circuit de détection. Les circuits 40 et 60 sont alors configurés pour que l'interrupteur de contournement 66 du circuit 40 soit à l'état passant durant la phase de détection du circuit 60, et pour que l'interrupteur de contournement 68 du circuit 60 soit à l'état passant durant la phase de détection du circuit 40, les phases de détection des circuits 40 et 60 étant disjointes.

On s'intéresse ici plus particulièrement au cas où les circuits de la puce inférieure 3 et ceux de la puce supérieure 5 contiennent des données confidentielles.

En fonctionnement normal, la présence de la puce supérieure 5 du côté de la face arrière de la puce inférieure 3 empêche un pirate d'accéder à la face arrière de la puce 3 pour procéder à une attaque de la puce 3, et la présence de la puce inférieure 3 du côté de la face arrière de la puce supérieure 5 empêche un pirate d'accéder à la face arrière de la puce 5 pour procéder à une attaque de la puce 5. La boucle 39 est intacte, et aucun des circuits de détection 40 et 60 ne détecte d'attaque.

Lors d'une tentative d'attaque visant à obtenir des données confidentielles présentes dans la puce inférieure 3, le pirate retire la puce supérieure 5 pour accéder à la face arrière de la puce inférieure 3. Le pirate tente alors de faire fonctionner la puce 3. La boucle 39 étant interrompue ou modifiée, le circuit de détection 60 produit un signal d'alerte A1 qui déclenche des contre-mesures destinées à faire échouer l'attaque de la puce inférieure 3.

De façon similaire, si le pirate tente de faire fonctionner la puce 5 pour analyser son fonctionnement, le circuit 40 détecte l'interruption ou la modification de la boucle 39 et déclenche des contre-mesures destinées à faire échouer l'attaque de la puce 5.

Ainsi, dans le dispositif 20C, chacune des puces 5 et 3 est protégée contre des attaques par sa face arrière.

La figure 7 est une vue en coupe schématique d'une variante de réalisation du dispositif 20C de la figure 6. La figure 7 illustre plus particulièrement un dispositif 20D comportant des éléments similaires à ceux du dispositif 20C de la figure 6, agencés d'une manière similaire. Les éléments communs aux deux dispositifs ne seront pas décrits à nouveau ci-après. Dans la suite, seules les différences entre les dispositifs 20D et 20C seront mises en exergue.

Le dispositif 20D comprend une boucle supplémentaire 39A et un circuit de détection 60A d'une caractéristique électrique de la boucle 39A. Le circuit de détection 60A est par exemple identique ou similaire au circuit de détection 40. Dans l'exemple représenté, le circuit de détection 60 du dispositif 20C de la figure 6 a été omis.

La boucle 39A a une partie située dans la puce 5. Cette partie est similaire à la partie de la boucle 39A située dans la puce 5 du dispositif 20B de la figure 5, à savoir que la boucle 39A comprend deux vias traversants supplémentaires 30E et 30F, et une piste 36B comprise dans la couche d'interconnexion 14 reliant les extrémités 32E et 32F des vias 30E et 30F à des plots respectifs 17E et 17F situés en face arrière de la puce 5.

La boucle 39A comprend en outre deux vias traversants supplémentaires 30E' et 30F' compris dans la puce inférieure 3. Les vias 30E' et 30F' ont, côté face avant, des extrémités respectives 32E' et 32F' et, côté face arrière, des extrémités 34E' et 34F'. Les extrémités 34E' et 34F' sont reliées à des plots de connexion supplémentaires, respectivement 17E' et 17F', situés en face arrière de la puce 3. La boucle 39A comprend une piste supplémentaire 38E, située dans la couche d'interconnexion 8 de la puce inférieure 3 et reliant les extrémités 32E' et 32F' des vias 30E' et 30F'. Les plots de connexion 17E' et 17F' sont brasés respectivement aux plots de connexion 17E et 17F.

La boucle 39A du dispositif 20D comprend ainsi, en série et dans cet ordre, dans la puce 5, le via 30E, la piste 36B et le via 30F, et, dans la puce 3, le via 30F', la piste 38E et le via 30E'.

Dans le dispositif 20D ainsi obtenu, la puce supérieure 5 est protégée par la boucle 39 et par le circuit de détection 40 contre des attaques depuis sa face arrière, et la puce inférieure 3 est protégée par la boucle 39A et par le circuit de détection 60A contre des attaques depuis sa face arrière.

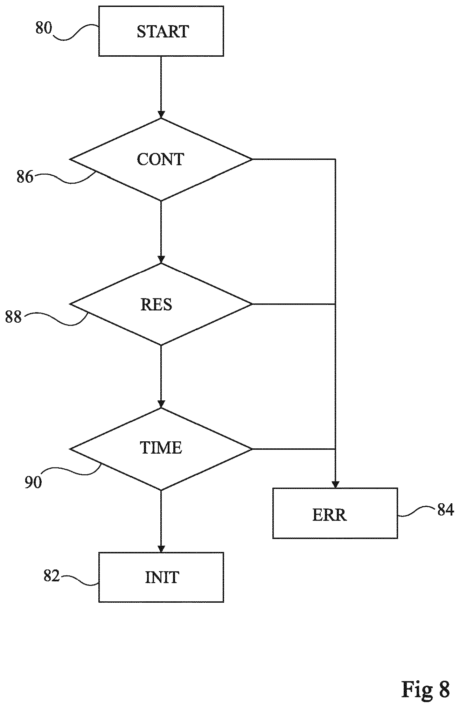

La figure 8 est un diagramme illustrant un exemple d'un mode de réalisation d'un procédé de commande d'un dispositif comprenant un empilement de puces électroniques. Ce procédé peut être mis en oeuvre par un circuit de détection, tel que l'un des circuits de détection 40, 60 ou 60A décrits précédemment, pour détecter une éventuelle attaque d'une puce du dispositif en surveillant des caractéristiques électriques d'une boucle telle que les boucles 39 et 39A décrites précédemment.

Le procédé démarre à une étape 80 (START) qui correspond par exemple à la connexion de la puce comprenant le circuit de détection à une source d'alimentation. Le procédé se termine soit par une étape 82 (INIT), soit par une étape 84 (ERR). L'étape 82 correspond au démarrage normal des circuits de la puce, en vue d'assurer les fonctions prévues pour la puce, par exemple en utilisant les données confidentielles de la puce. L'étape 82 est mise en oeuvre uniquement si aucune attaque n'est détectée. L'étape 84 correspond à la mise en oeuvre de contre-mesures destinées à contrer une attaque.

Après l'étape 80, le procédé comprend une étape 86 (CONT) à laquelle la continuité électrique de la boucle surveillée est testée pour le circuit de détection. Si une discontinuité est détectée, l'étape de contre-mesures 84 est mise en oeuvre. Sinon, le procédé se poursuit par une étape 88 (RES).

A l'étape 88, la résistance électrique de la boucle surveillée est comparée à une valeur de référence par le circuit de détection. La valeur de référence correspond par exemple à la résistance de la boucle en l'absence d'attaque. La valeur de référence peut correspondre à la résistance d'une autre boucle, par exemple dans le mode de réalisation de la figure 5 qui correspond à l'invention revendiquée, la boucle surveillée est la boucle 39 et la valeur de référence est celle de la boucle supplémentaire 39A. Si la différence entre la résistance de la boucle et la valeur de référence dépasse, en valeur absolue, un seuil, une étape de contre-mesures 84 est mise en oeuvre. Sinon, le procédé se poursuit par une étape 90 (TIME).

A l'étape 90, le circuit de détection émet une impulsion électrique dans la boucle surveillée. Par exemple, le circuit de détection applique à la boucle surveillée un front montant de potentiel entre des valeurs basse et haute de potentiel. Le circuit de détection compare à une durée de référence le temps mis par l'impulsion pour parcourir la boucle surveillée. La durée de référence correspond par exemple au temps de parcours en l'absence d'attaque. La durée de référence peut correspondre au temps mis par une impulsion pour parcourir une autre boucle, par exemple, dans le mode de réalisation de la figure 5, la boucle surveillée est la boucle 39 et la durée de référence est celle que met une impulsion pour parcourir la boucle supplémentaire 39A. Si la différence entre le temps de parcours et la durée de référence est supérieure, en valeur absolue, à un seuil, le procédé passe à l'étape de contre-mesures 84. Sinon, la puce démarre normalement à l'étape 82.

L'étape 86 permet de détecter une attaque d'un pirate ayant séparé les puces. Le pirate peut ensuite vouloir reconstituer les liaisons entre les puces, tout en maintenant un accès à la face arrière qu'il cherche à attaquer. Les nouvelles connexions modifient la résistance de la boucle et/ou le temps de parcours d'une impulsion dans la boucle. L'attaque est alors détectée à l'étape 88 ou 90, puis est contrée. Un avantage de surveiller plusieurs caractéristiques électriques de la boucle est que l'on obtient ainsi un niveau de protection particulièrement élevé.

A titre de variante, le nombre de caractéristiques électriques vérifiées successivement peut être différent de 3. De plus l'ordre des vérifications successives des caractéristiques de la boucle peut être différent de ce qui a été décrit dans l'exemple de la figure 8.

Un mode de réalisation de l'invention et des exemples utiles à la compréhension de l'invention ont été décrits. Diverses variantes et modifications selon l'invention dont l'étendue est définie par les revendications apparaîtront à l'homme de l'art. En particulier, bien que des pistes 36 et 38 décrites en relation avec la figure 3 aient des formes de serpentin disposées dans un plan situé au-dessus du niveau des pistes d'interconnexion des circuits, le serpentin peut être, en partie ou en totalité, situé entre des pistes d'interconnexion. En outre, bien que des formes de serpentins soient décrites, toute autre forme de piste adaptée est possible.

Par ailleurs, bien que le mode de réalisation et les exemples décrits comprennent une ou deux boucles, il est possible de prévoir plus de deux boucles.

En outre, bien que le mode de réalisation et les exemples décrits comprennent deux puces, on peut prévoir des dispositifs comportant des empilements de plus de deux puces.

Un mode de réalisation selon l'invention et plusieurs exemples avec diverses variantes ont été décrits ci-dessus. On notera que l'homme de l'art peut combiner divers éléments décrits ci-dessus. Les combinaisons faisant partie de l'invention sont limitées uniquement pat l'étendue des revendications. En particulier, les pistes 36A, 36B, 38A, 38B, 38C, 38D des boucles 39, 39A décrites en relation avec les figures 4 à 7 peuvent avoir des formes de serpentins telles que les formes en serpentins des pistes 36 et 38 décrites en relation avec la figure 3.

En outre, les boucles 39, 39A décrites en relation avec les figures 5, 6 et 7 peuvent chacune comprendre plus de deux paires de vias supplémentaires reliés en série par des pistes disposées alternativement dans la puce inférieure 3 et dans la puce supérieure 5, de la manière décrite en relation avec la figure 4.

De plus, on peut prévoir un dispositif comportant un empilement de deux puces ayant chacune sa face arrière tournée vers l'autre puce, comprenant deux boucles 39 et 39A telles que décrites en relation avec la figure 7, chacune des deux puces comportant un circuit de détection d'une caractéristique électrique des deux boucles tel que le circuit de détection 40 décrit en relation avec la figure 5, les deux boucles étant communes aux deux circuits de détection de la manière décrite en relation avec la figure 6 pour une seule boucle commune.

## Revendications

1. Dispositif comprenant :
une première puce (5) ayant une face avant et une face arrière ;
une deuxième puce (3) empilée avec la première puce et située du côté de la face arrière de la première puce ;
une première boucle (39) comportant :
- des premier (30A) et deuxième (30B) vias traversants situés dans la première puce et ayant chacun une première extrémité (32A, 32B) du côté de la face avant de la première puce et une deuxième extrémité (34A, 34B) du côté de la face arrière de la première puce ;
- une première piste (36) reliant les premières extrémités des premier et deuxième vias traversants et située dans la première puce du côté de sa face avant ; et
- une deuxième piste (38) reliant les deuxièmes extrémités des premier et deuxième vias traversants et située dans la deuxième puce ; et
au moins une deuxième boucle (39A) comportant :
- des troisième (30E) et quatrième (30F) vias traversants, situés dans la première puce (5) et ayant chacun une première extrémité (32E, 32F) du côté de la face avant de la première puce et une deuxième extrémité (34E, 34F) du côté de la face arrière de la première puce ;
- une troisième piste (36B), reliant les premières extrémités (32E, 32F) des troisième et quatrième vias traversants et située dans la première puce du côté de sa face avant ; et
- une quatrième piste (38C ; 38E), reliant les deuxièmes extrémités (34E, 34F) des troisième et quatrième vias traversants et située dans la deuxième puce (3),
la première puce comprenant un premier circuit de détection (40) d'une caractéristique électrique de la première boucle, le premier circuit (40) étant adapté à détecter au moins l'une des caractéristiques électriques suivantes des première (39) et deuxième (39A) boucles :
une continuité électrique entre la première boucle et la deuxième boucle ; et
une différence entre la résistance électrique de la première boucle et celle de la deuxième boucle.

2. Dispositif selon la revendication 1, dans lequel :
la première puce (5) comprend sur sa face arrière des premier (17A) et deuxième (17B) plots de connexion connectés respectivement aux premier et deuxième vias traversants (30A, 30B) ; et
la deuxième puce (3) comprend des troisième (9A ; 17A') et quatrième (9B ; 17B') plots de connexion connectés à la deuxième piste (38),
les premier et deuxième plots étant brasés respectivement aux troisième et quatrième plots de la deuxième puce.

3. Dispositif selon la revendication 1 ou 2, dans lequel le circuit de détection (40) est adapté à détecter au moins l'une des caractéristiques électriques suivantes de la première boucle (39) :
une absence de continuité électrique de la première boucle ;
une différence entre la valeur de la résistance électrique de la première boucle et une valeur de référence ; et
une différence entre le temps mis par une impulsion électrique pour parcourir la première boucle et une durée de référence.

4. Dispositif selon l'une quelconque des revendications 1 à 3, dans lequel la première boucle (39) comporte en outre au moins des cinquième (30C) et sixième (30D) vias traversants situés dans la première puce (5), la première boucle passant alternativement par la première puce et par la deuxième puce.

5. Dispositif selon l'une quelconque des revendications 1 à 4, dans lequel la première piste (36) présente un motif en serpentin.

6. Dispositif selon l'une quelconque des revendications 1 à 5, dans lequel la deuxième piste (38) présente un motif en serpentin.

7. Dispositif selon l'une quelconque des revendications 1 à 6, dans lequel la deuxième puce (3) a une face avant et a une face arrière tournée vers la première puce (5), la deuxième piste (38D) étant située du côté de la face avant de la deuxième puce, la deuxième puce comprenant :
des septième (30A') et huitième (30B') vias traversants reliant la deuxième piste (38) aux premier (30A) et deuxième (30B) vias traversants ; et
un deuxième circuit de détection (60) d'une caractéristique électrique de la première boucle (39).

8. Dispositif selon l'une quelconque des revendications 1 à 7, dans lequel la deuxième puce (3) comprend un troisième circuit de détection (60A) d'une caractéristique électrique de la deuxième boucle (39A).

9. Dispositif selon l'une quelconque des revendications 1 à 8, dans lequel le premier circuit (40) est adapté à déclencher la mise en oeuvre de contre-mesures destinées à stopper une attaque de la première puce (5) lorsque ladite caractéristique électrique est détectée.

## Patentansprüche

1. Eine Vorrichtung, die Folgendes aufweist:
einen ersten Chip (5) mit einer Vorderseite und einer Rückseite;
einen zweiten Chip (3), der mit dem ersten Chip gestapelt ist und sich an der Rückseite des ersten Chips angeordnet ist; und
eine erste Schleife (39), aufweisend:
- erste (30A) und zweite (30B) Durchkontaktierungen, die in dem ersten Chip angeordnet sind und jeweils ein erstes Ende (32A, 32B) an der Vorderseite des ersten Chips und ein zweites Ende (34A, 34B) an der Rückseite des ersten Chips aufweisen
- eine erste Leiterbahn (36), die die ersten Enden der ersten und zweiten Durchkontaktierungen verbindet und die an dem ersten Chip an dessen Vorderseite angeordnet ist; und
- eine zweite Leiterbahn (38), die die zweiten Enden der ersten und zweiten Durchkontaktierungen verbindet und die in dem zweiten Chip angeordnet ist; und
wenigstens eine zweite Schleife (39A), aufweisend:
- dritte (30E) und ein vierte (30F) Durchkontaktierungen, die in dem ersten Chip (5) angeordnet sind und jeweils ein erstes Ende (32E, 32F) an der Vorderseite des ersten Chips und ein zweites Ende (34E, 34F) an der Rückseite des ersten Chips aufweisen
- eine dritte Leiterbahn (36B), die die ersten Enden (32E, 32F) der dritten und vierten Durchkontaktierung verbindet und in dem ersten Chip an dessen Vorderseite angeordnet ist; und
- eine vierte Leiterbahn (38C; 38E), die die zweiten Enden (34E, 34F) der dritten und vierten Durchkontaktierungen verbindet und in dem zweiten Chip (3) angeordnet ist,
wobei der erste Chip eine erste Schaltung (40) zum Detektieren einer elektrischen Eigenschaft der ersten Schleife aufweist, wobei die erste Schaltung (40) zum Detektieren wenigstens einer der folgenden elektrischen Eigenschaften der ersten (39) und zweiten (39A) Schleife angepasst ist
eine elektrische Kontinuität zwischen der ersten Schleife und der zweiten Schleife; und
eine Differenz zwischen dem elektrischen Widerstand der ersten Schleife und der zweiten Schleife.

2. Vorrichtung nach Anspruch 1, wobei:
der erste Chip (5) an seiner Rückseite erste (17A) und zweite (17B) Anschlussflächen aufweist, die mit den ersten beziehungsweise zweiten Durchkontaktierungen (30A, 30B) verbunden sind; und
der zweite Chip (3) dritte (9A; 17A') und vierte (9B; 17B') Anschlussflächen aufweist, die mit der zweiten Leiterbahn (38) verbunden sind,
wobei die erste und die zweite Anschlussfläche mit der dritten beziehungsweise der vierten Anschlussfläche des zweiten Chips verlötet sind.

3. Vorrichtung nach Anspruch 1 oder 2, wobei die Detektierschaltung (40) in der Lage ist, mindestens eine der folgenden elektrischen Eigenschaften der ersten Schleife (39) zu detektieren.
einen Mangel an elektrischer Kontinuität der ersten Schleife;
eine Differenz zwischen dem Wert des elektrischen Widerstands der ersten Schleife und einem Referenzwert; und
eine Differenz zwischen der Zeit, die ein elektrischer Impuls benötigt, um die erste Schleife durchzulaufen, und einer Referenzdauer.

4. Vorrichtung nach einem der Ansprüche 1 bis 3, wobei die erste Schleife (39) ferner mindestens dritte (30C) und vierte (30D) Durchkontaktierungen aufweist, die in dem ersten Chip (5) angeordnet sind, wobei die erste Schleife abwechselnd durch den ersten Chip und durch den zweiten Chip verläuft.

5. Vorrichtung nach einem der Ansprüche 1 bis 4, wobei die erste Leiterbahn (36) ein Serpentinenmuster aufweist.

6. Vorrichtung nach einem der Ansprüche 1 bis 5, wobei die zweite Leiterbahn (38) ein Serpentinenmuster aufweist.

7. Vorrichtung nach einem der Ansprüche 1 bis 6, wobei der zweite Chip (3) eine Vorderseite und eine dem ersten Chip (5) zugewandte Rückseite aufweist, wobei die zweite Leiterbahn (38D) an der Vorderseite des zweiten Chips angeordnet ist, wobei der zweite Chip Folgendes aufweist:
siebte (30A') und achte (30B') Durchkontaktierungen, die die zweite Leiterbahn (38) mit den ersten (30A) und zweiten (30B) Durchkontaktierungen verbinden; und
eine zweite Schaltung (60) zum Detektieren einer elektrischen Eigenschaft der ersten Schleife (39).

8. Vorrichtung nach einem der Ansprüche 1 bis 7, wobei der zweite Chip (3) eine dritte Schaltung (60A) zum Detektieren einer elektrischen Eigenschaft der zweiten Schleife (39A) aufweist.

9. Vorrichtung nach einem der Ansprüche 1 bis 7, wobei die erste Schaltung (40) konfiguriert ist zum Auslösen der Implementierung von Gegenmaßnahmen, die dazu bestimmt sind, einen Angriff auf den ersten Chip (5) zu stoppen, wenn die elektrische Eigenschaft detektiert wird.

## Claims

1. A device comprising:
a first chip (5) having a front side and a back side;
a second chip (3) stacked with the first chip and located on the back side of the first chip; and
a first loop (39) comprising:
- first (30A) and second (30B) through vias located in the first chip and each having a first end (32A, 32B) on the front side of the first chip and a second end (34A, 34B) on the back side of the first chip;
- a first track (36) connecting the first ends of the first and second through vias and located in the first chip on the front side thereof; and
- a second track (38) connecting the second ends of the first and second through vias and located in the second chip; and
at least a second loop (39A) comprising:
- third (30E) and fourth (30F) through vias located in the first chip (5) and each having a first end (32E, 32F) on the front side of the first chip and a second end (34E, 34F) on the back side of the first chip;
- a third track (36B) connecting the first ends (32E, 32F) of the third and fourth through vias and located in the first chip on the front side thereof; and
- a fourth track (38C; 38E) connecting the second ends (34E, 34F) of the third and fourth through vias and located in the second chip (3),
the first chip comprising a first circuit (40) for detecting an electrical characteristic of the first loop, the first circuit (40) being adapted for detecting a least one of the following electrical characteristics of the first (39) and second (39A) loops:
an electric continuity between the first loop and the second loop; and
a difference between the electric resistance of the first loop and of the second loop.

2. The device of claim 1, wherein:
the first chip (5) comprises on its back side first (17A) and second (17B) connection pads respectively connected to the first and second through vias (30A, 30B); and
the second chip (3) comprises third (9A; 17A') and fourth (9B; 17B') connection pads connected to the second track (38),
the first and second pads being respectively soldered to the third and fourth pads of the second chip.

3. The device of claim 1 or 2, wherein the detection circuit (40) is capable of detecting at least one of the following electrical characteristics of the first loop (39) :
a lack of electric continuity of the first loop;
a difference between the value of the electric resistance of the first loop and a reference value; and
a difference between the time taken by an electric pulse to follow the first loop and a reference duration.

4. The device of any of claims 1 to 3, wherein the first loop (39) further comprises at least third (30C) and fourth (30D) through vias located in the first chip (5), the first loop alternately running through the first chip and through the second chip.

5. The device of any of claims 1 to 4, wherein the first track (36) has a serpentine pattern.

6. The device of any of claims 1 to 5, wherein the second track (38) has a serpentine pattern.

7. The device of any of claims 1 to 6, wherein the second chip (3) has a front side and has a back side facing the first chip (5), the second track (38D) being located on the front side of the second chip, the second chip comprising:
seventh (30A') and eighth (30B') through vias connecting the second track (38) to the first (30A) and second (30B) through vias; and
a second circuit (60) for detecting an electrical characteristic of the first loop (39).

8. The device of any of claims 1 to 7, wherein the second chip (3) comprises a third circuit (60A) for detecting an electrical characteristic of the second loop (39A).

9. The device of any of claims 1 to 7, wherein the first circuit (40) is configured to trigger the implementation of countermeasures intended to stop an attack of the first chip (5) when said electrical characteristic is detected.
